(19) Europäisches Patentamt
European Patent Office
Office européen des brevets

(11) **EP 1 702 220 B1**

(12) **FASCICULE DE BREVET EUROPEEN**

(45) Date de publication et mention de la délivrance du brevet:
**08.08.2018 Bulletin 2018/32**

(21) Numéro de dépôt: **04791507.9**

(22) Date de dépôt: **08.10.2004**

(51) Int Cl.:
***G01R 33/02*** *(2006.01)*

(86) Numéro de dépôt international:
**PCT/FR2004/002560**

(87) Numéro de publication internationale:
**WO 2005/036193 (21.04.2005 Gazette 2005/16)**

(54) **SONDE DE MESURE D UN CHAMP MAGNETIQUE**

MAGNETFELD-MESSSONDE

MAGNETIC-FIELD-MEASURING PROBE

(84) Etats contractants désignés:
**AT BE BG CH CY CZ DE DK EE ES FI FR GB GR HU IE IT LI LU MC NL PL PT RO SE SI SK TR**

(30) Priorité: **08.10.2003 FR 0311773**

(43) Date de publication de la demande:
**20.09.2006 Bulletin 2006/38**

(73) Titulaire: **CENTRE NATIONAL D'ETUDES SPATIALES**
**75001 Paris (FR)**

(72) Inventeurs:
- **DESPLATS, Romain**
  **31320 CASTANET TOLOSAN (FR)**
- **CREPEL, Olivier**
  **31700 Mondeville (FR)**
- **BEAUDOIN, Félix**
  **Union City, CA 94587 (US)**
- **PERDU, Philippe**
  **31100 Toulouse (FR)**

(74) Mandataire: **Gaillarde, Frédéric F. Ch. et al**
**Cabinet Germain & Maureau**
**31-33, rue de la Baume**
**75008 Paris (FR)**

(56) Documents cités:
DE-A- 19 725 200       US-A- 5 132 620
US-A1- 2002 167 313       US-B1- 6 427 314

EP 1 702 220 B1

**Description**

La présente invention concerne une sonde de mesure d'un champ magnétique du type comportant au moins un capteur magnéto-résistif ou magnéto-inductif sensible au champ magnétique suivant un axe de mesure privilégié déterminé

Il est connu de mesurer le champ magnétique engendré par un circuit électronique en fonctionnement par mise en oeuvre d'un capteur magnéto-résistif et, plus précisément, d'un capteur de type GMR (Giant Magnetic Resistor).

De tels capteurs magnéto-résistifs sont des éléments électroniques dont la résistance varie en fonction du champ magnétique dans lequel ils sont placés. Aux capteurs magnéto-résistifs est reliée une chaîne de traitement permettant de déterminer l'intensité du champ magnétique au-dessus du circuit. Un tel capteur est divulgué dans le brevet US 6,427,314 B1.

De tels capteurs sont certes efficaces mais ne permettent d'obtenir qu'un nombre réduit d'informations concernant le rayonnement électromagnétique produit par le circuit électronique. En particulier, les caractéristiques du courant circulant dans le circuit, notamment son intensité, le chemin qu'il emprunte et son sens de circulation ne peuvent être déterminés.

L'invention a pour but de proposer une sonde de mesure d'un champ magnétique permettant d'obtenir des informations supplémentaires concernant le circuit analysé.

A cet effet, l'invention a pour objet un dispositif de mesure d'un champ magnétique engendré par un circuit, conforme à la revendication 1.

Suivant des modes particuliers de réalisation, le dispositif de mesure comporte une ou plusieurs des caractéristiques des revendications 2 à 9.

L'invention sera mieux comprise à la lecture de la description qui va suivre, donnée uniquement à titre d'exemple et faite en se référant aux dessins sur lesquels :

- la Figure 1 est une vue en perspective d'une installation d'analyse d'un circuit intégré ;
- la Figure 2 est un organigramme explicitant le fonctionnement de l'installation de la figure 1 ;
- la Figure 3 est une vue en perspective schématique d'un exemple d'une sonde de mesure ;
- la Figure 4 est une vue schématique d'un premier mode de réalisation d'un dispositif de mesure d'un champ magnétique selon l'invention ;
- les Figures 5 et 6 sont des vues identiques à celles de la Figure 4 de variante de réalisation d'un dispositif de mesure ;
- la Figure 7 est une vue en perspective schématique d'un dispositif manuel de mesure d'un champ magnétique incorporant une sonde de mesure différentielle bidirectionnelle ;
- la Figure 8 est une vue schématique de la sonde de mesure du dispositif de la Figure 7 ;
- la Figure 9 est une vue schématique en perspective d'un capteur différentiel tridimensionnel permettant de déterminer toutes les caractéristiques d'un courant circulant à partir du champ magnétique engendré par la circulation de ce courant ;
- la Figure 10 est une installation de test d'un ensemble de circuits intégrés ;
- la Figure 11 est une vue schématique d'un premier mode de réalisation d'une sonde de mesure matricielle ; et
- la Figure 12 est une vue en élévation schématique d'un second mode de réalisation d'une sonde de mesure matricielle.

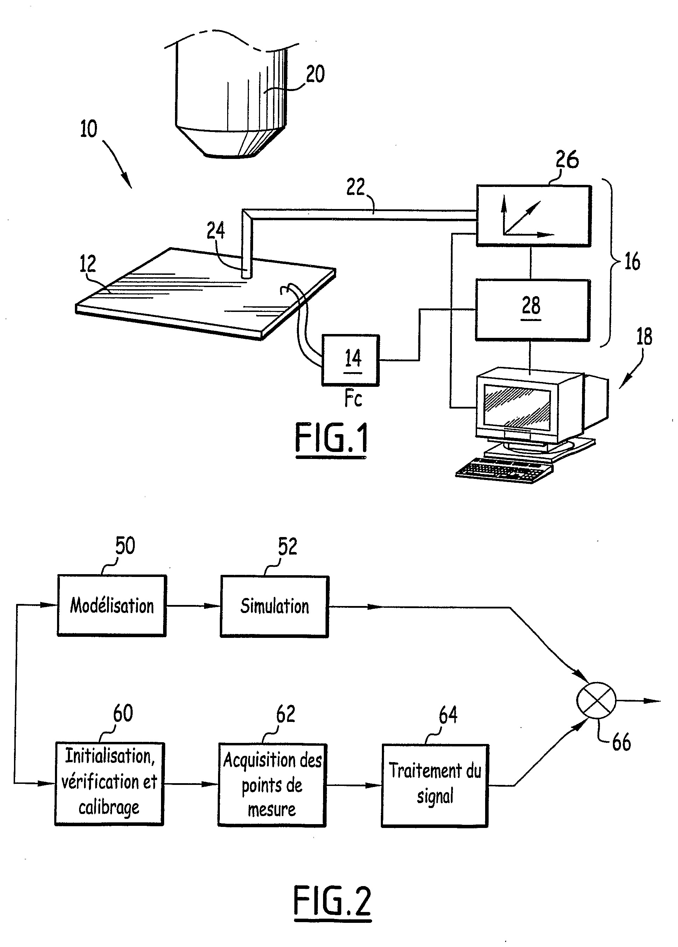

L'installation illustrée sur la figure 1 est destinée à l'analyse d'un circuit intégré en fonctionnement.

Cette installation comporte essentiellement un plateau 12 de support d'un circuit intégré C, un circuit 14 d'excitation du circuit intégré à une fréquence prédéterminée notée FC, un dispositif 16 d'analyse du champ magnétique engendré par le circuit C en fonctionnement et des moyens 18 d'exploitation des résultats obtenus en sortie du dispositif d'analyse du champ magnétique 16. En outre, l'installation comporte des moyens d'observation 20 du circuit intégré en fonctionnement. Ces moyens sont connus en soi et ne seront pas décrits en détail.

Le support 12 sur lequel est posé le circuit C est formé d'une plaque de mu-métal ou comporte dans sa partie inférieure opposée au circuit une plaque de mu-métal formant une barrière au champ magnétique. Avantageusement, le circuit C est confiné dans une boîte de mu-métal.

Le circuit d'excitation 14 est formé par exemple d'un générateur de fréquence propre à alimenter le circuit à la fréquence prédéterminée FC. Cette fréquence d'excitation FC est par exemple de 160 kHz.

Les moyens d'analyse 16 comportent un bras manipulateur 22 équipé, à son extrémité libre, d'une sonde de mesure 24 propre à déterminer une valeur caractéristique du champ magnétique à l'endroit de la sonde.

Le bras manipulateur 22 est relié à un mécanisme 26 de déplacement de la sonde, permettant, comme connu en soi, de déplacer celle-ci suivant trois directions perpendiculaires les unes aux autres et de connaître avec précision la position de la sonde par rapport au circuit.

En outre, les moyens d'analyse 16 comportent des chaînes de traitement 28 auxquelles sont reliés les capteurs de la sonde 24 pour la mise en forme du signal issu de la sonde. Ces chaînes de traitement sont reliées aux moyens d'exploitation 18 pour fournir à ceux-ci une ou plusieurs valeurs traitées du champ magnétique relevé par la sonde 24.

Les moyens d'exploitation 18 sont formés par exemple par un ordinateur de type PC comportant des cartes d'acquisition reliées en sortie des chaînes de traitement 28. Il comporte en outre des cartes de commande permettant le pilotage des moyens d'analyse 16, et plus précisément, des moyens de déplacement 26, des chaînes de traitement 28 et du circuit d'excitation 14.

Les moyens d'exploitation 18 comportent des modules logiciels permettant le pilotage des moyens d'analyse 16 du champ magnétique, et notamment du circuit d'excitation 14, des moyens de déplacement 26 et des chaînes de traitement 28. Ils comportent en outre des modules logiciels de traitement des signaux issus des moyens d'analyse du champ.

En particulier, les moyens d'exploitation 18 sont propres à mettre en oeuvre l'algorithme illustré sur la figure 2, un module logiciel étant prévu pour chaque étape de l'algorithme.

Pour l'analyse d'un circuit électronique en fonctionnement, une modélisation du circuit peut d'abord être effectuée, à l'étape 50, à partir du tracé du circuit. Cette modélisation, par exemple vectorielle, est conduite à l'aide de tout logiciel adapté. Cette modélisation vise à déterminer la position des différentes pistes et des différents composants électroniques constituant le circuit C.

A l'issue de cette modélisation, une simulation du fonctionnement du circuit est effectuée à l'étape 52. Les caractéristiques du champ magnétique au-dessus du circuit sont déterminées par cette simulation, en chaque point du circuit, notamment par application des équations de Maxwell. Ainsi, il est déterminé, pour chaque élément du circuit, le courant circulant dans celui-ci, ainsi que les trois composantes du champ magnétique notées $B_x$, $B_y$ et $B_z$, en un point de mesure situé immédiatement au-dessus du circuit et pour différentes positions prédéterminées pouvant être occupées par la sonde de mesure 24.

Parallèlement aux étapes de modélisation et de simulation, les moyens d'exploitation 18 commandent une mesure effective du champ magnétique par les moyens d'analyse du champ 16 en chaque point de mesure considéré lors de la simulation.

A l'étape 60, les moyens d'analyse du champ 16 sont d'abord initialisés et calibrés. Leur fonctionnement correct est également vérifié. En outre, des mesures de référence sont effectuées sur un échantillon de calibration connu dont les composantes du champ magnétique qu'il crée sont connues.

Une acquisition des différents points de mesure est ensuite effectuée à l'étape 62. Cette étape consiste à effectuer une mesure d'au moins une composante du champ magnétique en plusieurs points de mesure prédéterminés au-dessus du circuit C en fonctionnement. A cet effet, la sonde est déplacée sous la commande des moyens de déplacement 26 pour balayer la surface du circuit, par exemple en suivant un chemin en boustrophédon. Avant chaque acquisition d'une mesure, la sonde de mesure est arrêtée au point de mesure, afin que le résultat de la mesure ne soit pas affecté par le déplacement de la sonde.

L'acquisition proprement dite de chaque mesure sera décrite dans la suite.

Avantageusement mais non obligatoirement, l'étape 62 prévoit également l'acquisition de points de mesure alors que le circuit C n'est pas en fonctionnement, afin de mesurer en chaque point de mesure la ou les composantes du champ magnétique ambiant.

A l'étape 64, le signal acquis pour chaque point de mesure est traité afin notamment de corriger les erreurs et décalages résultant de la mesure, ces erreurs et décalages étant corrigés par des techniques de comparaison avec la table de données acquises sur un échantillon de référence, lors de l'étape 60.

Lors de l'étape 64, des valeurs issues des mesures du champ suivant une ou plusieurs directions notées $B_x$, $B_y$, $B_z$ sont calculées et notamment les variations spatiales des composantes du champ suivant les trois directions notées $dB_x/dy$, $dB_x/dz$, $dB_y/dz$, $dB_y/dx$, $dB_z/dx$ et $dB_z/dy$.

En outre, les caractéristiques d'intensité et de direction du courant dans le circuit au-dessous du point de mesure sont déterminées par application de la loi de Maxwell J = Rot B où J est le vecteur courant et B le vecteur champ magnétique.

A l'étape 66, les valeurs issues de l'étape du traitement de signal 64 et les valeurs obtenues suite à la simulation effectuée à l'étape 52 sont comparées afin de déduire si le fonctionnement réel du circuit est correct ou non, et déterminer les zones de discordance entre le circuit théorique et le circuit réel en fonctionnement.

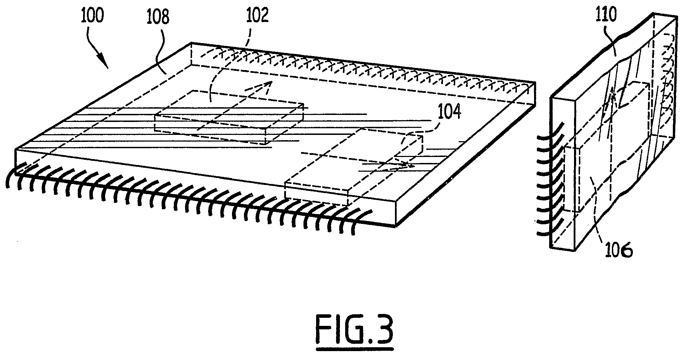

La tête de mesure 24 comporte une sonde de mesure 100 constituée comme illustré sur la Figure 3 de deux circuits intégrés comportant chacun un ou plusieurs capteurs magnéto-résistifs. Selon l'invention, la sonde de mesure comporte au moins deux capteurs magnéto-résistifs, ayant des axes de mesure privilégiés décalés angulairement. Les capteurs sont liés rigidement les uns aux autres et sont ainsi immobilisés dans leurs positions relatives prédéterminées.

Dans le mode de réalisation illustré sur la Figure 3, trois capteurs résisto-magnétifs 102, 104, 106 sont intégrés à la sonde de mesure.

Pour des raisons de facilité de fabrication, les deux capteurs magnéto-résistifs 102, 104 sont disposés dans un même circuit intégré 108 alors que le capteur magnéto-résistif 106 est disposé dans un circuit intégré séparé 110.

Chaque capteur magnéto-résistif est un composant dont la résistance varie en fonction du champ magnétique dans lequel il se trouve. Un tel capteur présente un axe de mesure privilégié représenté schématiquement par une flèche sur les figures. La résistance du composant est ainsi influencée par la composante du champ magnétique suivant cet axe de mesure privilégié, le composant étant peu sensible aux composantes du champ magnétique suivant d'autres directions.

Comme illustré sur la Figure 3, les axes de mesure privilégiés des capteurs magnéto-résistifs sont perpendiculaires deux à deux de sorte que ces axes définissent un repère orthogonal de l'espace.

Bien qu'une telle disposition des axes soit particulièrement avantageuse, les axes de mesure privilégiés des différents capteurs peuvent être seulement décalés angulairement les uns des autres, sans qu'ils soient perpendiculaires les uns aux autres.

Le capteur magnéto-résistif peut être de type GMR (Giant Magneto Resistive), de type GMI (Giant Magneto Impedance) de type CMR (Cellossol Magneto Resistive) ou de type TMR (Tunneling Magneto Resistive). De préférence, le capteur magnéto-résistif est de ce dernier type. Il peut s'agir par exemple de capteurs de type MTJ (Magnetic Tunnel Junction) ou de type SDT (Spin Dépendent Tunneling).

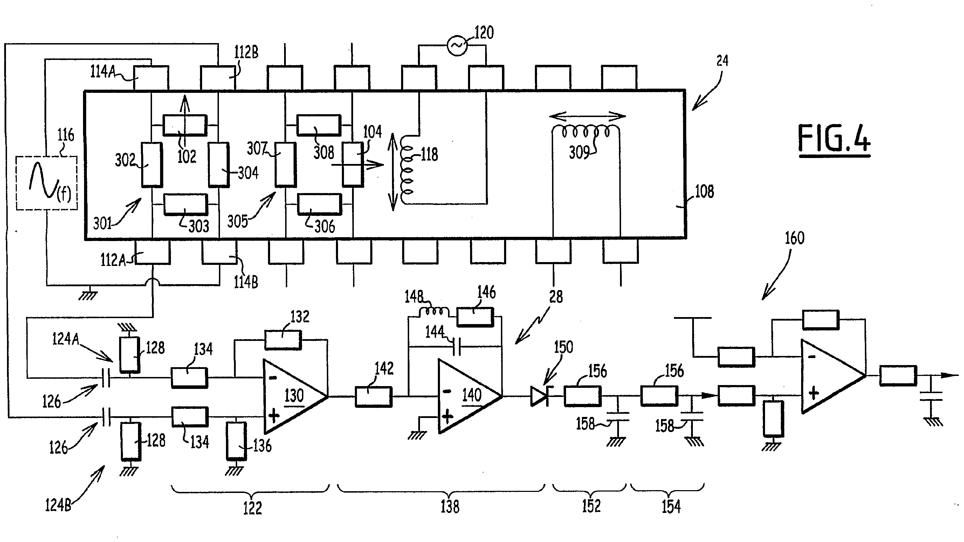

Sur la Figure 4, seul le circuit intégré 108 comportant les capteurs 102 et 104 est représenté. De plus, seul le circuit de traitement 28 associé au capteur 102 est illustré, sachant qu'un circuit de traitement identique est mis en oeuvre pour le capteur 104.

Comme illustré sur la figure 4, le capteur magnéto-résistif 102 est intégré dans un pont de Weston 201 comportant trois autres résistances fixes de valeur prédéterminée 302, 303, 304. Les quatre résistances sont reliées en série pour former une boucle, comme connu en soi dans la structure d'un pont de Weston. Deux des bornes opposées du pont de Weston forment des sorties 112A, 112B de mesure de la sonde 100. Les deux autres bornes du pont de Weston 114A, 114B forment des entrées d'alimentation du pont de Weston. Celles-ci sont reliées aux bornes d'un générateur 116 produisant un signal sinusoïdal de fréquence prédéterminée, cette fréquence étant par exemple égale à 160 KHz.

En outre, et comme connu en soi, la sonde de mesure 100 comporte un bobinage 118 relié à une source extérieure de tension alternative 120. Le bobinage 118 est adapté pour créer un champ de polarisation dans la région du capteur magnéto-résistif afin de réduire l'hystérésis du capteur.

De même, le capteur magnéto-résistif 104 est également intégré dans un pont de Weston 305 comportant trois résistances 306, 307, 308, et un second bobinage 309 est prévu pour créer un champ de polarisation dans la région du capteur magnéto-résistif 104 afin de réduire l'hystérésis. Comme précédemment, le pont de Weston et le bobinage sont reliés à des moyens d'alimentation propres qui ne sont pas représentés pour des raisons de simplification.

Seul le circuit de traitement des signaux issu du capteur magnéto-résistif 102 est décrit dans la suite étant entendu que le circuit relié aux capteurs 104 est identique.

Les sorties 112A, 112B de la sonde de mesure sont reliées à la chaîne de traitement 28.

Celles-ci sont reliées, en entrée, à un étage d'amplification différentielle 122 formant soustracteur par l'intermédiaire de deux filtres passe-haut 124A, 124B aux entrées desquelles sont connectées, respectivement, les bornes de sortie 112A et 112B.

L'étage d'amplification différentielle 122 est dimensionné pour produire un gain, par exemple égal à 100.

Les filtres passe-haut sont des filtres passifs de type RC comportant un condensateur 126 dont une borne est reliée à la masse par une résistance 128.

L'étage d'amplification différentielle est de tout type connu adapté et comporte, par exemple, un amplificateur opérationnel 130 dont la boucle de contre-réaction est équipée d'une résistance 132, les entrées inverseuses et non-inverseuses de l'amplificateur opérationnel étant reliées aux sorties des filtres 124A, 124B par deux résistances d'entrée 134. La borne non-inverseuse de l'amplificateur opérationnel est reliée à la masse par une résistance 136 fixant une tension d'entrée.

La sortie de l'amplificateur différentiel 120 est reliée à l'entrée de moyens 138 d'isolement d'une composante fréquentielle déterminée du signal représentatif du champ magnétique issu de la sonde de mesure. La fréquence de la composante du champ à déterminer est notée FI. Cette fréquence est par exemple égale à 160 kHz.

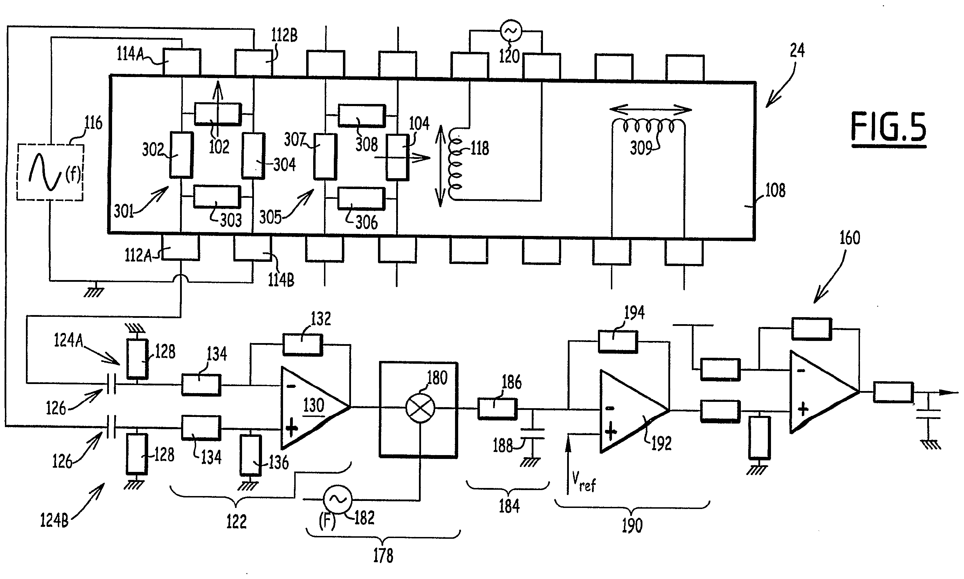

Dans le mode de réalisation illustré sur la figure 5, ces moyens d'isolement 138 comportent un filtre sélectif actif du type passe-bande centré sur la fréquence FI de la composante fréquentielle à isoler. Cette fréquence est égale à la fréquence F d'excitation du circuit C.

Ce filtre comporte un amplificateur opérationnel 140 dont la borne non-inverseuse est reliée à la masse. La borne inverseuse du filtre est reliée à la sortie de l'étage d'amplification différentielle 122 par une résistance d'entrée 142. La boucle de contre-réaction de l'amplificateur différentiel 140 comprend un condensateur 144 relié en parallèle à une résistance 146, elle-même connectée en série avec une bobine 148.

En sortie, le filtre sélectif 138 présente une diode 150 de type BAT suivie de deux filtres passe-bas passifs 152, 154, chacun formé d'une résistance dont la borne de sortie est reliée à la masse par un condensateur 158.

La chaîne de traitement 28 permet d'obtenir la composante fréquentielle du champ magnétique détecté par le capteur magnéto-résistif à l'aide d'un circuit très simple.

Lors du fonctionnement du dispositif de mesure du champ magnétique, la valeur de la résistance du capteur magnéto-résistif 102 varie en fonction de l'intensité du champ magnétique suivant l'axe de mesure privilégié du capteur. Ainsi, l'amplitude du si

gnal mesuré aux bornes de sortie 112A, 112B varie en fonction du champ magnétique.

Les deux filtres passe-haut 124A, 124B assurent un filtrage des fréquences perturbatrices résultant de l'environnement extérieur.

Le circuit d'amplification différentielle 122 produit en sortie un signal dont l'intensité est proportionnelle à la différence de potentiel entre les deux bornes 122A, 122B. Le filtre sélectif 138 centré sur la fréquence d'excitation du circuit C assure l'isolement de la composante fréquentielle du champ pour cette fréquence.

Les deux filtres passe-bas 152, 154 assurent un nouveau filtrage permettant la suppression des composantes perturbatrices.

Un étage de sortie 160 peut avantageusement être ajouté de manière en enlever la valeur de tension continue mesurée au borne du capteur à vide. Pour cela un amplificateur différentiel est à nouveau utilisé. Le signal de sortie précédent est injecté sur l'entrée inverseuse de l'amplicateur différentielle. Alors que la tension continue de référence est injectée sur l'entrée non inverseuse.

Le réglage de la tension de référence se fait par ajustement de la valeur de la résistance ajustable de manière à mesure une valeur nulle en sortie de ce deuxième amplicateur différentiel. La mesure se fait en polarisant le capteur magnétiquement (pour se décaler dans le cycle d'hystérésis) sans polariser le circuit C.

Le signal issu de la chaîne de traitement est recueilli par les moyens d'exploitation 18.

Ainsi, on comprend que la chaîne de traitement permet l'obtention très rapide d'une valeur de mesure du champ magnétique et plus précisément d'une composante de ce champ magnétique.

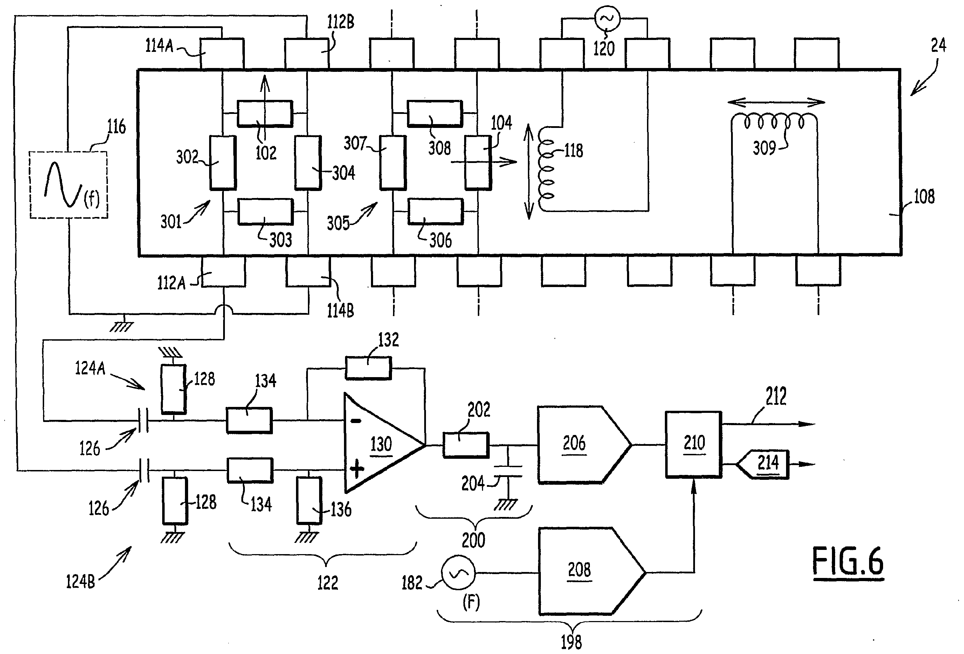

Sur les figures 5 et 6 sont représentées des variantes de réalisation d'un dispositif de mesure selon l'invention. Dans ces modes de réalisation, les éléments identiques ou analogues à ceux de la figure 4 sont désignés par les mêmes numéros de référence.

Dans ces deux variantes de réalisation, seule la chaîne de traitement diffère, par les moyens mis en oeuvre en aval de l'étage d'amplification différentielle 122.

Dans les deux cas, les moyens d'isolement de la composante fréquentielle du champ magnétique pour une fréquence prédéterminée comportent un circuit multiplicateur 180 permettant de combiner le signal issu de l'étage d'amplification différentielle 122 et un signal de référence, dont la fréquence FC est supérieure ou égale à la fréquence f de fonctionnement du circuit imposée par le circuit d'excitation 14. L'utilisation du multiplicateur donne de la flexibilité quant au choix de la fréquence (160 KHz)

Dans le mode de réalisation de la figure 4, les moyens d'isolement comportent un circuit multiplicateur analogique 180 dont une entrée est connectée en sortie de l'étage d'amplification différentielle 122 et dont l'autre entrée est reliée à un générateur de tension sinusoïdal 182 dont la fréquence de référence F est supérieure à la fréquence prédéterminée FI de la composante fréquentielle à isoler.

Un filtre passe-bas 184 constitué d'une résistance 186 et d'un condensateur 188 est prévu en sortie du circuit multiplicateur. Avantageusement, un circuit soustracteur 190 est prévu en sortie du filtre passe-bas 184 pour assurer la comparaison du signal filtré obtenu en sortie à un signal de référence noté Vref imposé. Le circuit soustracteur comporte un amplificateur opérationnel 192 dont la boucle de contre-réaction présente une résistance 194 adaptée et sur la borne non-inverseuse duquel une tension Vref est appliquée.

Comme dans le mode de réalisation de la figure 4, un étage de sortie 160 est disposé en sortie du circuit soustracteur.

Suivant un mode particulier de réalisation, la source de tension 182 est formée par la source de tension 116 alimentant le pont de Weston 201.

Dans ce mode la fréquence d'alimentation du capteur est identique à la fréquence de la composante fréquentielle recherchée.

Dans le mode de réalisation de la figure 6, les moyens d'isolement de la composante fréquentielle déterminée sont formés d'un calculateur numérique assurant la multiplication du signal obtenu en sortie de l'étage d'amplification différentielle 122 et d'un signal de référence.

Comme illustré sur la figure 6, un filtre passe-bas 200 constitué d'une résistance 202 et d'un condensateur 204 est prévu en sortie de l'étage d'amplification différentielle. Un convertisseur analogique/numérique 206 est connecté en sortie du filtre 200 afin d'assurer une numérisation du signal.

En outre, la chaîne de traitement intègre, comme précédemment, une source notée également 182, d'une tension sinusoïdale de référence. Un convertisseur analogique/numérique 208 est relié en sortie de cette source 182. Les convertisseurs analogiques/numériques ont une fréquence d'échantillonnage très supérieure à la fréquence des signaux reçus. Celle-ci est par exemple supérieure à 500 kHz.

Un calculateur rapide 210, tel qu'un circuit de type DSP est prévu dans la chaîne de traitement. Il reçoit en entrée les signaux issus des deux convertisseurs analogiques 206 et 208 et est programmé pour assurer une multiplication des deux signaux.

Les signaux multipliés sont ainsi adressés aux moyens d'exploitation 18, soit par une liaison numérique telle qu'une liaison de type RS232 notée 212, ou au travers d'une liaison analogique, un convertisseur numérique/analogique 214 étant relié en sortie du calculateur 210.

Dans ce cas, la multiplication des deux signaux est effectuée par le calculateur 210. L'opération de soustraction effectuée par l'étage de sortie 160 dans les figures 3 et 4 est également assurée par le calculateur 210.

Avec une sonde de mesure selon l'invention, pour chaque position de mesure de la sonde, trois composantes du champ magnétique noté $B_x$, $B_y$, et $B_z$ correspondant à trois directions du champ perpendiculaires sont mémorisées, ces trois composantes du champ magnétique étant chacune déterminée par un capteur magnéto-résistif 102, 104, 106 associé à une chaîne de traitement propre.

Les trois composantes du champ magnétique sont déterminées pour chaque point de mesure, lesquels points de mesure s'étendent suivant toute la surface du circuit à analyser. Ces points sont par exemple répartis sur une matrice régulière couvrant la surface du circuit. Pour une même position par rapport au plan du circuit, deux points de mesure sont effectués à des distances différentes par rapport à la surface du circuit à analyser.

A partir des trois composantes du champ magnétique déterminées pour des points voisins, les moyens de calcul 18 déterminent, pour chaque composante, la dérivée du champ magnétique par rapport à une direction, notamment en effectuant la différence des valeurs des composantes du champ magnétique entre ces deux points et en divisant cette différence par la distance séparant les deux points.

A partir de ces valeurs, les moyens d'exploitation 18 sont propres à calculer pour chaque point de mesure les trois composantes caractéristiques du courant circulant dans le circuit. Ces composantes du champ magnétique sont déterminées par les équations suivantes :

$$J_x = \frac{dB_z}{dy} - \frac{dB_y}{dz}$$

$$J_y = \frac{dB_x}{dz} - \frac{dB_z}{dx}$$

$$J_z = \frac{dB_y}{dx} - \frac{dB_x}{dy}$$

où $J_x$, $J_y$ et $J_z$ sont les trois composantes du courant suivant les trois axes de mesure privilégiés capteurs 102, 104 et 106.

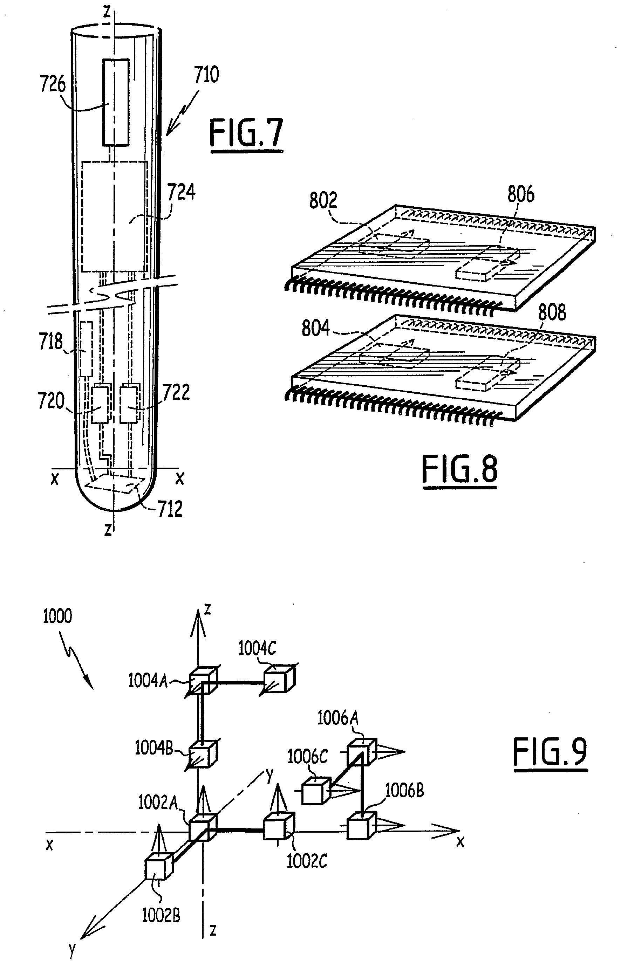

Sur la figure 7 est représenté un dispositif portable 710 de mesure du courant circulant dans un circuit suivant une unique direction.

Le dispositif 710 se présente sous la forme d'un ustensile allongé d'axe Z-Z dont la forme et les dimensions correspondent généralement à celles d'un stylo. Ce dispositif est donc adapté pour être déplacé manuellement au-dessus du circuit en fonctionnement avec son axe Z-Z perpendiculaire au circuit.

Le dispositif comporte à une extrémité une sonde 712 comportant plusieurs capteurs magnéto-résistifs disposés dans deux plans parallèles perpendiculaires à l'axe Z-Z.

La sonde 712 est illustrée à plus grande échelle sur la figure 8. Elle comporte quatre capteurs magnéto-résistifs 802, 804, 806, 808 répartis en deux paires de capteurs, les capteurs d'une même paire ayant leurs axes de mesure privilégiés parallèles l'un à l'autre. Les axes de mesure privilégiés des deux paires de capteurs sont perpendiculaires les uns aux autres et s'étendent ainsi suivant deux directions principales de l'espace qui sont toutes deux perpendiculaires à l'axe Z-Z du dispositif.

Les capteurs d'une même paire sont décalés l'un par rapport à l'autre suivant une direction transversale à leurs axes de mesure privilégiés communs. Plus précisément, les capteurs d'une même paire sont décalés suivant l'axe Z-Z du dispositif.

Dans ce mode de réalisation, deux capteurs 802, 806 sont disposés sur un premier circuit intégré, alors que deux autres capteurs 804, 808 sont disposés sur un autre circuit intégré disposé parallèlement au premier. Les capteurs 602, 604, 606, 608 sont ainsi répartis suivant deux plans parallèles.

Les capteurs 802 et 804 sont décalés suivant l'axe Z-Z alors que leurs axes de mesure privilégiés s'étendent suivant l'axe Y-Y. De même, les capteurs 806, 808 sont décalés suivant l'axe Z-Z mais leurs axes de mesure privilégiés s'étendent suivant l'axe X-X perpendiculaire aux axes Y-Y et Z-Z.

Le dispositif 710 comporte des moyens 718 d'alimentation des quatre capteurs.

De même, la sonde 712 comporte des bornes de sortie propres à chaque capteur permettant de recueillir un signal représentatif du champ magnétique mesuré par ce capteur.

Chaque capteur est relié à une chaîne de traitement propre 720, 722 permettant le conditionnement du signal issu du capteur. Ces chaînes de traitement sont identiques à l'une des chaînes de traitement décrites sur les figures 4, 5 et 6. Elles sont reliées à une unité de traitement d'informations 24 propre à traiter les signaux représentatifs des composantes du champ magnétique obtenu en sortie des chaînes de traitement 720, 722. Le dispositif comprend en outre un écran d'affichage 726 piloté par l'unité de traitement d'informations 724.

L'écran 726 est propre à afficher les valeurs des deux composantes $J_x$ et $J_y$ du courant circulant dans le circuit au-dessus duquel le dispositif 710 est placé perpendiculairement au plan du circuit.

$J_x$ et $J_y$ sont les valeurs des composantes du courant suivant les directions X-X et Y-Y propres à la sonde et correspondant aux axes de mesure privilégiés des capteurs.

Pour ce faire, l'unité de traitement d'informations 724 détermine la valeur de la dérivée notée $\frac{dB_x}{dz}$ de la composante du champ magnétique B suivant l'axe X-X du dispositif par rapport à la direction longitudinale Z-Z passant par les deux capteurs 806, 808.

En sortie des chaînes de traitement reliées aux capteurs 806, 808, deux valeurs de la composante du champ magnétique B suivant la direction X-X notées $B_{x1}$ et $B_{x2}$ sont fournies. A partir de ces deux valeurs de mesure et de la distance connue séparant les capteurs 806 et 808 mesurée suivant l'axe Z-Z, l'unité de traitement d'informations 24 détermine une évaluation de la dérivée

$\dfrac{dB_x}{dz}$ de la composante du champ magnétique suivant la direction X-X par rapport à la direction Z-Z à partir de la relation $\dfrac{dB_x}{dz} = \dfrac{B_{x2} - B_{x1}}{z_2 - z_1}$ où $z_2$ et $z_1$ sont les positions des capteurs 14 et 12 suivant l'axe Z-Z.

La valeur de la composante $j_y$ du courant circulant dans le circuit suivant la direction Y-Y perpendiculaire aux deux directions X-X et Z-Z est égale à $\dfrac{dB_x}{dz}$.

De manière analogue, la valeur $J_x$ du courant est obtenue à partir de la différence des deux valeurs de champs $B_{y1}$ et $B_{y2}$ fournies par les capteurs 802, 804 et de la distance connue les séparant à partir de la relation

$$J_x = - \frac{dB_y}{dz} = \frac{B_{y1} - B_{y2}}{z_2 - z_1}$$

L'utilisation de deux plans de deux capteurs dans les directions X-X et Y-Y. permet à la recherche de courant dans le plan perpendiculaire à l'axe Z-Z du dispositif. Les mesures différentielles de champs entre les capteurs deux à deux : dB$_x$/dz et dB$_y$/dz permettent de remonter à l'expression vectorielle du courant avec les équations de Maxwell : Jx et Jy puisque dBz/dy et dBz/dx sont nuls si le courant ne circule que dans le plan perpendiculaire à l'axe du dispositif.

Suivant un mode de réalisation particulier de l'installation de la figure 1 ou du dispositif de la figure 7, la tête de mesure 24 ou 712 est constituée par exemple d'une sonde 1000 telle qu'illustrée sur la figure 9. Cette sonde est adaptée pour effectuer une mesure différentielle du champ suivant trois directions perpendiculaires deux-à-deux.

Une telle sonde comporte neuf capteurs. Ces neuf capteurs sont répartis sous forme de trois triplets de capteurs, les capteurs d'un même triplet ayant leurs axes de mesure privilégiés disposés parallèlement l'un à l'autre. Ces capteurs sont en outre décalés les uns des autres suivant deux directions perpendiculaires à l'axe de mesure privilégié caractérisant le triplet.

Plus précisément, dans l'exemple illustré sur la figure 9, trois capteurs 1002A, 1002B, 1002C ont leurs axes de mesure privilégiés disposés parallèlement à l'axe X-X. Ces capteurs 1002A et 1002B sont décalés l'un de l'autre suivant l'axe X-X alors que les capteurs 1002A et 1002B sont décalés suivant l'axe X-X. De même, les capteurs 1004A, 1004B, 1004C ont leur axe de mesure privilégié parallèle à l'axe Y-Y, le capteur 1004C étant décalé du capteur 1004A suivant l'axe X-X alors que le capteur 1004B est décalé du capteur 1004A suivant l'axe Z-Z. Enfin, les trois capteurs 1006A, 1006B, 1006C ont leur axe de mesure s'étendant parallèlement à l'axe X-X, les capteurs 1006A et 1006B étant décalés par rapport au capteur 1006A respectivement suivant l'axe Z-Z et suivant l'axe Y-Y.

Dans l'installation décrite en regard de la figure 1, chaque capteur est relié à une chaîne de traitement propre et les neuf valeurs de champ sont fournies au moyen d'exploitation 18. En outre, les moyens d'exploitation 18 connaissent la distance séparant les différents capteurs d'un même triplet suivant les directions perpendiculaires aux axes de mesure privilégiés des capteurs de ce triplet. Ainsi, pour chaque point de mesure, les moyens d'exploitation déterminent à partir des composantes mesurées par les capteurs la variation de chaque composante du champ magnétique suivant chacune des directions. A partir de ces différentes variations, les différentes composantes notées $j_x$, $j_y$ et $j_z$ suivant les trois directions perpendiculaires X-X, Y-Y et Z-Z du courant circulant dans le circuit en test C sont calculées grâce au relation suivante :

$$J_x = \frac{dB_z}{dy} - \frac{dB_y}{dz}$$

$$J_y = + \frac{dB_x}{dz} - \frac{dB_z}{dx}$$

$$J_z = \frac{dB_y}{dx} - \frac{dB_x}{dy}$$

On conçoit qu'avec un tel dispositif, le courant circulant dans le circuit peut être déterminé avec précision pour chaque point de mesure. En multipliant les points de mesure, la structure du circuit en test peut être reconstituée et son fonctionnement dynamique peut être analysée avec précision. Des moyens analogues sont mis en oeuvre dans le dispositif portable 710.

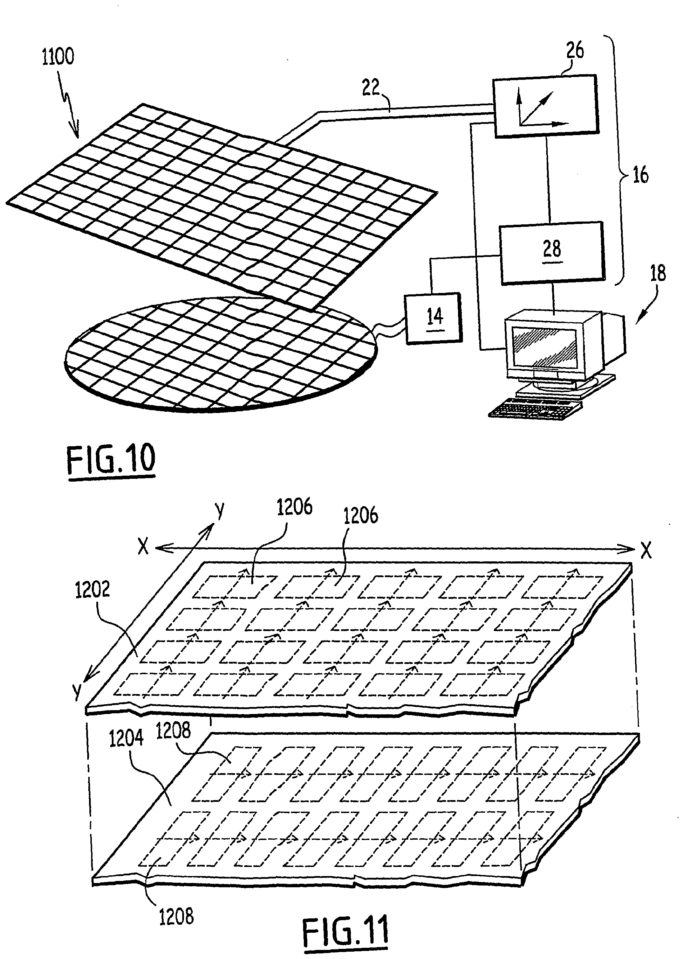

Sur la figure 10 est représentée une variante de la figure 1. Dans ce mode de réalisation, la tête de mesure 24 est remplacée par une matrice 1100 comportant un ensemble de capteurs disposés régulièrement en ligne et en colonne. Cette matrice de capteurs permet le test d'un ensemble de circuits intégrés portés par une galette de silicium 1102, les circuits étant disposés côte à côte. La matrice de capteurs comporte des groupes de capteurs répartis en lignes et en colonnes et correspondant chacun à un circuit à tester de la galette 1102.

Un groupe de capteurs est partiellement représenté sur la figure 11. Un tel groupe de capteurs comporte par exemple 5000 capteurs magnéto-résistifs disposés eux-mêmes en lignes et en colonnes. Chacun de ces capteurs est relié au dispositif d'analyse par l'intermédiaire d'un circuit de traitement propre. Les groupes de capteurs comportent des capteurs dont les axes de mesure privilégiés sont disposés parallèlement les uns aux autres suivant deux directions perpendiculaires l'une à l'autre. Ces directions perpendiculaires s'étendent dans un plan parallèle au plan général des circuits à tester. En effet, la composante du courant perpendiculairement au plan principal du circuit est généralement de peu d'intérêt.

Cette matrice est utilisée pour acquérir rapidement une image du champ magnétique d'une galette de circuits intégrés. Pour une matrice de taille donnée, les capteurs seront répartis sur deux plans. Un plan suivant la direction X et l'autre plan suivant la direction Y.

Avantageusement, une seconde matrice, identique à la précédente est utilisée, tournée de 90 degrés. Ainsi, le plan de dessous, précédemment X devient le plan Y et le plan de dessus devient le plan X. En utilisant ces deux matrices on aura un ensemble de mesure de champ X et champ Y à deux altitudes Z données. En combinant ces mesures de manière différentielle entre les deux altitudes, l'expression du courant suivant les équations de maxwell sont alors obtenues.

Dans le mode de réalisation, de la figure 11, la matrice de capteur comporte deux couches superposées 1202, 1204. Chaque couche comporte un réseau régulier de capteurs magnéto-résistifs. Les capteurs 1206 de la première couche sont disposés avec leurs axes de mesure privilégiés parallèles, les capteurs étant répartis en lignes et en colonnes perpendiculaires les unes aux autres. De même, la seconde couche comporte des capteurs 1208 dont les axes de mesure privilégiés sont parallèles les uns aux autres et perpendiculaires aux axes de mesure des capteurs de la première couche.

Sur les deux couches, les capteurs sont espacés les uns des autres suivant une direction perpendiculaire à leur axe de mesure privilégié et s'étendant dans le plan de la couche portant les capteurs d'un pas prédéterminé connu. Ainsi, dans l'exemple considéré, au droit de chaque capteur, les moyens d'exploitation déterminent les composantes $j_x$ et $j_y$ du courant circulant dans le plan principal du circuit à partir des relations suivantes :

$$J_x = -\frac{dBy}{dz}$$

$$J_y = \frac{dBx}{dz}$$

Pour obtenir ces valeurs, la matrice est amenée successivement dans deux positions d'écartement distinct suivant la direction Z-Z par rapport au circuit à tester. Des mesures sont faites dans ces deux positions séparées d'un intervalle $d_z$ et les quantités $dB_y$ et $dB_x$ sont calculées par soustraction des valeurs relevées.

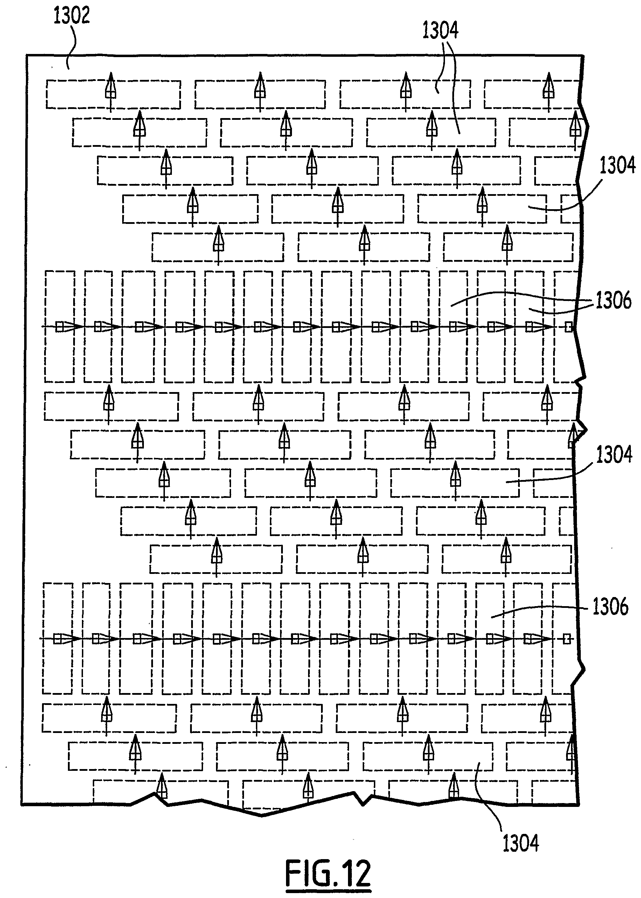

Sur la figure 12 est représenté un autre mode de réalisation d'une sonde selon l'invention, cette sonde constituant un groupe de capteurs de la matrice de capteurs 1100 de la figure 10.

Dans ce mode de réalisation, les différents capteurs magnéto-résistifs sont définis sur une même couche 1302 d'un matériau supra-conducteur. Chaque capteur présente une forme rectangulaire, l'élément magnéto-résistif n'étant formé que par la partie centrale du capteur schématisé par un carré sur la figure.

Cette sonde est constituée d'une alternance de plusieurs lignes de capteurs ayant un axe de mesure privilégié disposé suivant une première direction X-X et de ligne de capteurs dont l'axe de mesure privilégié s'étend suivant un axe Y-Y. Plus précisément, cinq lignes de capteurs magnéto-résistifs 1304 ayant leurs axes de mesure privilégiés parallèles à l'axe X-X se succèdent suivant l'axe X-X. Les capteurs sont décalés d'une ligne à l'autre d'une distance égale à 1/5$^{ème}$ de la longueur d'un capteur magnéto-résistif, la longueur étant prise perpendiculairement à l'axe de mesure privilégié. La ligne de capteurs notés 1306 dont l'axe de mesure privilégié est orienté suivant l'autre direction de mesure est constituée d'un alignement de capteurs magnéto-résistifs alignés rigoureusement suivant le même axe.

Cette configuration prend en compte la nature rectangulaire des capteurs magnéto-résistifs. Suivant la taille du rectangle par rapport à l'élément active de mesure de champ située au centre du rectangle le rapport 1/5 est modifié.

Avantageusement, une deuxième matrice est disposée parallèlement, dans un plan au dessus de la première. Cette deuxième matrice est organisée d'une manière comparable mais, alternativement, l'ensemble des capteurs suivant l'axe Y-Y est positionné au dessus de l'ensemble des capteurs suivant l'axe X-X et les capteurs suivant l'axe X-X au dessus des capteurs suivant l'axe Y-Y. Ainsi, une mesure différentielle entre des capteurs suivant l'axe X-X entre les deux plans est obtenue après balayage. La mesure différentielle est faite deux à deux entre deux mesures d'un capteur suivant l'axe X-X d'un plan inférieur à un endroit donné et d'un capteur suivant l'axe X-X du plan supérieur au même endroit. Après balayage l'ensemble de la surface est couverte par une mesure des champs $B_X$ et $B_Y$ sur deux plans (deux altitudes z) en tout point.

En variante, les capteurs magnéto-résistifs sont remplacés par des capteurs magnéto-inductifs.

## Revendications

1. Dispositif de mesure d'un champ magnétique engendré par un circuit (C), comportant :

   - au moins une sonde de mesure du champ magnétique comportant au moins deux capteurs magnéto-résistifs ou magnéto-inductifs (102, 104, 106), chaque capteur magnéto-résistif ou magnéto-inductif (102, 104, 106) étant sensible au champ magnétique suivant un axe de mesure privilégié déterminé, lesdits capteurs magnéto-résistifs ou magnéto-inductifs (102, 104, 106) étant rigidement liés l'un à l'autre dans une position telle que leurs axes de mesure privilégiés sont décalés angulairement, la sonde comportant des bornes de sortie propres à chaque capteur magnéto-résistif ou magnéto-inductif (102, 104, 106) pour fournir un signal représentatif du champ magnétique mesuré par chaque capteur suivant son axe de mesure privilégié ;
- une chaîne de traitement (28 ; 720, 722) propre à chaque capteur magnéto-résistif ; et
- des moyens d'exploitation (18 ; 724) des signaux issus des différentes chaînes de traitement ; **caractérisé par** les moyens d'exploitation (18 ; 724) étant propres à calculer la dérivée du champ magnétique mesuré par chacun des capteurs suivant son axe de mesure privilégié, par rapport à l'axe de mesure d'un autre capteur ; les moyens d'exploitation (18 ; 724) étant propres en outre à calculer la différence entre chaque couple desdites dérivées pour déterminer au moins une composante caractéristique d'un courant circulant dans le circuit (C).

2. Dispositif de mesure selon la revendication 1, **caractérisé en ce que** la sonde comporte au moins deux capteurs magnéto-résistifs ou magnéto-inductifs (102, 104) formés dans un même substrat semi-conducteur, les deux capteurs ayant des axes de détection privilégiés disposés perpendiculairement l'un à l'autre.

3. Dispositif de mesure selon la revendication 1 ou 2, **caractérisé en ce que** la sonde comporte au moins trois capteurs magnéto-résistifs ou magnéto-inductifs (102, 104, 106) dont les axes de mesure privilégiés sont perpendiculaires deux à deux.

4. Dispositif de mesure selon l'une quelconque des revendications précédentes, **caractérisé en ce que** la sonde comporte au moins deux paires de capteurs magnéto-résistifs ou magnéto-inductifs (802, 804, 806, 808), les capteurs de chaque même paire ayant leurs axes privilégiés parallèles et décalés l'un de l'autre suivant une direction transversale à leurs axes de mesure privilégiés et les axes de mesure privilégiés des capteurs de deux paires distinctes sont décalés angulairement.

5. Dispositif de mesure selon la revendication 4, **caractérisé en ce que** la sonde comporte au moins neuf capteurs magnéto-résistifs ou magnéto-inductifs (1002A, 1002B, 1002C, 1004A, 1004B, 1004C, 1006A, 1006B, 1006C) répartis en trois triplets de trois capteurs, les trois capteurs d'un même triplet ayant leurs axes de mesure privilégiés parallèles et décalés les uns des autres suivant des directions transversales à leurs axes de mesure privilégiés et les axes de mesure privilégiés des capteurs de triplets distincts sont décalés angulairement.

6. Dispositif de mesure selon l'une quelconque des revendications précédentes, **caractérisé en ce que** tous les capteurs magnéto-résistifs ou magnéto-inductifs (1206, 1208) de la sonde sont répartis suivant deux couches (1202, 1204).

7. Dispositif de mesure selon la revendication 6, **caractérisé en ce que** les axes de mesure privilégiés des capteurs de couches différentes (1202, 1204) sont décalés angulairement.

8. Dispositif de mesure selon la revendication 6 ou 7, **caractérisé en ce que** les capteurs d'une même couche (1202, 1204) ont leurs axes de mesure privilégiés parallèles.

9. Dispositif de mesure selon l'une quelconque des revendications 1 à 5, **caractérisé en ce que** tous les capteurs magnéto-résistifs ou magnéto-inductifs (1304, 1308) de la sonde sont répartis sur une même couche (1302).

**Patentansprüche**

1. Vorrichtung zum Messen eines Magnetfeldes, welches von einem Schaltkreis (C) erzeugt wird, aufweisend:

   - mindestens eine Sonde zum Messen des Magnetfeldes, welche mindestens zwei magnetoresistive oder magnetoinduktive Sensoren (102, 104, 106) aufweist, wobei jeder magnetoresistive oder magnetoinduktive Sensor (102, 104, 106) auf das Magnetfeld entlang einer bestimmten bevorzugten Messachse sensitiv ist, wobei die besagten magnetoresistiven oder magnetoinduktiven Sensoren (102, 104, 106) starr miteinander in einer Position verbunden sind, sodass ihre bevorzugten Messachsen winkelversetzt sind, wobei die Sonde Ausgangspole aufweist, die zu jedem magnetoresistiven oder magnetoinduktiven Sensor (102, 104, 106) jeweilig gehören, um ein Signal bereitzustellen, welches repräsentativ für das Magnetfeld ist, welches mittels jedes Sensors entlang seiner bevorzugten Messachse gemessen ist,
   - eine Behandlungskette (28, 720, 722), die zu jedem magnetoresistiven Sensor jeweilig gehört, und
   - Mittel zur Auswertung (18, 724) von Signalen, die von unterschiedlichen Behandlungsketten stammen,

**dadurch gekennzeichnet, dass**
die Mittel zur Auswertung (18, 724) geeignet sind, um die Ableitung des Magnetfeldes, welches von jedem der Sensoren entlang seiner bevorzugten Messachse gemessen ist, bezüglich der Messachse eines anderen Sensors zu berechnen,
die Mittel zur Auswertung (18, 724) geeignet sind, um ferner die Differenz zwischen jedem Paar der besagten Ableitungen zu berechnen, um mindestens eine charakteristische Komponente eines Stroms zu ermitteln, der in dem Schaltkreis (C) fließt.

2. Mess-Vorrichtung gemäß Anspruch 1, **dadurch gekennzeichnet, dass** die Sonde mindestens zwei magnetoresistive oder magnetoinduktive Sensoren (102, 104) aufweist, die in einem selben Halbleiter-Substrat gebildet sind, wobei die zwei Sensoren bevorzugte Detektionsachsen haben, die senkrecht zueinander angeordnet sind.

3. Mess-Vorrichtung gemäß Anspruch 1 oder 2, **dadurch gekennzeichnet, dass** die Sonde mindestens drei magnetoresistive oder magnetoinduktive Sensoren (102, 104, 106) aufweist, deren bevorzugte Messachsen paarweise senkrecht sind.

4. Mess-Vorrichtung gemäß irgendeinem der vorherigen Ansprüche, **dadurch gekennzeichnet, dass** die Sonde mindestens zwei Paare an magnetoresistiven oder magnetoinduktiven Sensoren (802, 804, 806, 808) aufweist, wobei die Sensoren von jedem gleichen Paar ihre bevorzugten Achsen parallel und zueinander versetzt entlang einer Richtung, die senkrecht zu ihren bevorzugten Messachsen ist, haben, und die bevorzugten Messachsen der Sensoren von zwei verschiedenen Paaren winkelversetzt sind.

5. Mess-Vorrichtung gemäß Anspruch 4, **dadurch gekennzeichnet, dass** die Sonde mindestens neun magnetoresistive oder magnetoinduktive Sensoren (1002A, 1002B, 1002C, 1004A, 1004B, 1004C, 1006A, 1006B, 1006C) aufweist, die in drei Triplets von drei Sensoren aufgeteilt sind, wobei die drei Sensoren von einem gleichen Triplet ihre bevorzugten Messachsen parallel und versetzt zueinander entlang von Richtungen, die senkrecht zu ihren bevorzugten Messachsen sind, haben, und die bevorzugten Messachsen von Sensoren verschiedener Triplets winkelversetzt sind.

6. Mess-Vorrichtung gemäß irgendeinem der vorherigen Ansprüche, **dadurch gekennzeichnet, dass** alle magnetoresistiven oder magnetoinduktiven Sensoren (1206, 1208) der Sonde entlang von zwei Schichten (1202, 1204) aufgeteilt sind.

7. Mess-Vorrichtung gemäß Anspruch 6, **dadurch gekennzeichnet, dass** die bevorzugten Messachsen von Sensoren unterschiedlicher Schichten (1202, 1204) winkelversetzt sind.

8. Mess-Vorrichtung gemäß Anspruch 6 oder 7, **dadurch gekennzeichnet, dass** die Sensoren einer gleichen Schicht (1202, 1204) ihre bevorzugten Messachsen parallel haben.

9. Mess-Vorrichtung gemäß irgendeinem der Ansprüche 1 bis 5, **dadurch gekennzeichnet, dass** alle magnetoresistiven oder magnetoinduktiven Sensoren (1304, 1308) der Sonde an einer gleichen Schicht (1302) verteilt sind.

## Claims

1. Device for measuring a magnetic field generated by a circuit (C), comprising:

   - at least one probe for measuring a magnetic field comprising at least two magnetoresistive or magnetoinductive sensors (102, 104, 106),each magnetoresistive or magnetoinductive sensor being sensitive to the magnetic field along a predetermined selected measurement axis, the at least two magnetoresistive or magnetoinductive sensors (102, 104, 106) being rigidly connected to each other in a position such that their selected measurement axes are angularly offset, and the probe comprising output terminals which are specific to each magnetoresistive or magnetoinductive sensor (102, 104, 106) in order to provide a signal which is representative of the magnetic field measured by each sensor along the selected measurement axis thereof;
   - a processing chain (28; 720; 722) which is specific to each magnetoresistive sensor; and
   - means (18; 724) for processing the signals from the various processing chains;

   **characterized by**
   the processing means (18; 724) being able to calculate the derivative of the measured magnetic field by each of the sensors along its selected measurement axe, relative to the measurement axe of another sensor;
   the processing means (18; 724) being also able to calculate the difference between each couple of the said derivatives in order to determine at least one characteristic component of a current flowing in the circuit (C).

2. Measurement device according to claim 1, **characterised in that** it comprises at least two magnetoresistive or magnetoinductive sensors (102, 104) which are formed in the same semi-conductor substrate, the two sensors having selected detection axes which are arranged perpendicularly relative to each other.

3. Measurement device according to claim 1 or 2, **characterised in that** it comprises at least three magnetoresistive or magnetoinductive sensors (102, 104, 106) whose selected measurement axes are perpendicular in pairs.

4. Measurement device according to any one of the preceding claims, **characterised in that** it comprises at least two pairs of magnetoresistive or magnetoinductive sensors (802, 804, 806, 808), the sensors of each same pair having their selected axes parallel and offset relative to each other in a transverse direction relative to their selected measurement axes and the selected measurement axes of the sensors of two separate pairs are angularly offset.

5. Measurement device according to claim 4, **characterised in that** it comprises at least nine magnetoresistive or magnetoinductive sensors (1002A, 1002B, 1002C, 1004A, 1004B, 1004C, 1006A, 1006B, 1006C) which are distributed in three triplets of three sensors, the three sensors of the same triplet having their selected measurement axes parallel and offset relative to each other in transverse directions relative to their selected measurement axes and the selected measurement axes of the sensors of separate triplets are angularly offset.

6. Measurement device according to any one of the preceding claims, **characterised in that** all the magnetoresistive or magnetoinductive sensors (1206, 1208) of the probe are distributed in accordance with two layers (1202, 1204).

7. Measurement device according to claim 6, **characterised in that** the selected measurement axes of the sensors of different layers (1202, 1204) are angularly offset.

8. Measurement device according to claim 6 or 7, **characterised in that** the sensors of the same layer (1202, 1204) have their selected measurement axes parallel.

9. Measurement device according to any one of claims 1 to 5, **characterised in that** all the magnetoresistive or magnetoinductive sensors (1304, 1308) of the probe are distributed on the same layer (1302).

FIG.1

FIG.2

## FIG.3

FIG.4

**FIG.5**

FIG.6

FIG.7

FIG.8

FIG.9

1100

22

26

16

28

14

18

## FIG.10

y

X      X

1206    1206

1202

Y

1204   1208

1208

## FIG.11

1302

1304

1304

1306

1304

1306

1304

**FIG.12**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6427314 B1